(19) **Europäisches Patentamt**

**European Patent Office**

**Office européen des brevets**

(11) **EP 0 883 878 B1**

(12) **EUROPÄISCHE PATENTSCHRIFT**

(45) Veröffentlichungstag und Bekanntmachung des Hinweises auf die Patenterteilung:
**26.04.2000 Patentblatt 2000/17**

(51) Int Cl.⁷: **G11C 29/00**, G11C 16/06

(21) Anmeldenummer: **97915310.3**

(86) Internationale Anmeldenummer:
**PCT/DE97/00349**

(22) Anmeldetag: **27.02.1997**

(87) Internationale Veröffentlichungsnummer:
**WO 97/32312 (04.09.1997 Gazette 1997/38)**

(54) **SCHALTUNGSANORDNUNG FÜR EINEN PROGRAMMIERBAREN NICHTFLÜCHTIGEN SPEICHER**

CIRCUIT ARRANGEMENT FOR A PROGRAMMABLE NON-VOLATILE MEMORY

CIRCUIT DESTINE A UNE MEMOIRE NON VOLATILE PROGRAMMABLE

(84) Benannte Vertragsstaaten:
**DE FR GB IT**

(30) Priorität: **29.02.1996 DE 19607724**

(43) Veröffentlichungstag der Anmeldung:
**16.12.1998 Patentblatt 1998/51**

(73) Patentinhaber: **SIEMENS AKTIENGESELLSCHAFT**
**80333 München (DE)**

(72) Erfinder:
• **GEORGAKOS, Georg**
 **D-85447 Fraunberg (DE)**
• **KERN, Thomas**
 **D-85579 Neubiberg (DE)**

• **SOMMER, Diether**
 **D-80469 München (DE)**
• **ZETTLER, Thomas**
 **D-81737 München (DE)**

(56) Entgegenhaltungen:
**EP-A- 0 251 889**

• **PATENT ABSTRACTS OF JAPAN vol. 10, no. 371 (P-526), 11.Dezember 1986 & JP 61 165898 A (MATSUSHITA ELECTRONICS CORP.), 26.Juli 1986,**
• **PATENT ABSTRACTS OF JAPAN vol. 12, no. 417 (P-782), 7.November 1988 & JP 63 153797 A (FUJITSU LTD.), 27.Juni 1988,**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft eine Schaltungsanordnung für einen programmierbaren nichtflüchtigen Speicher gemäß dem Oberbegriff des Anspruchs 1.

Nichtflüchtige Speicher, insbesondere einmal programmierbare Speicherschaltungen (OTP = One Time Programmable Memory) werden zunehmend in integrierten Mikrocontrollerschaltungen und dergleichen eingesetzt. Ein derartiger Speicher unterscheidet sich von einem gewöhnlichen EPROM lediglich dadurch, daß bei der Endmontage ein Gehäuse ohne Fenster verwendet wird, wodurch ein Löschen des Speicherinhalts mittels UV-Licht nicht möglich ist und somit der Speicher nur ein einziges Mal beschrieben werden kann.

Ein Testen eines derartigen Speichers findet daher vor der Endmontage z.B. noch auf dem Wafer statt.

Mit zunehmender Kapazität des Speichers wird jedoch das Testen einer jeden Speicherzelle zeitaufwendig, da zum Beschreiben einer Speicherzelle ca. 50 µs benötigt werden. Hat der Speicher eine Kapazität von z.B. 1 Megabit, so wäre allein zum Beschreiben einer jeden Speicherzelle eine Zeit von ca. 50 sec pro I/O-Wortbreite notwendig. Bekannte Speicher weisen daher eine zusätzliche Schaltungsanordnung auf, die es erlaubt im Testbetrieb mehrere Speicherzellen parallel zu beschreiben. Derartige Speicher sind beispielsweise aus der EP 0 186 040 oder EP 0 186 051 bekannt.

Da der Programmierstrom gegenüber dem normalen Versorgungsstrom für das Bauelement realtiv hoch ist, ist jedoch nur eine begrenzte Anzahl von Speicherzellen gleichzeitig beschreibbar, da die Leitungen nur einen bestimmten maximalen Programmierstrom erlauben ohne daß der Baustein beschädigt wird.

Aufgabe der vorliegenden Erfindung ist es daher, eine Schaltungsanordnung für einen programmierbaren nichtflüchtigen Speicher anzugeben, die es erlaubt, die Testzeit eines derartigen Speichers zu verkürzen.

Diese Aufgabe wird durch den kennzeichnenden Teil des Anspruchs 1 gelöst. Weiterbildungen sind Kennzeichen der Unteransprüche. Ein Verfahren zum Betreiben einer erfindungsgemäßen Schaltungsanordnung ist im Anspruch 5 angegeben.

Die Erfindung macht sich die Tatsache zunutze, daß zum Programmieren einer Speicherzelle eines derartigen Speichers ein hoher Programmierstrom nur für eine relativ kurze Zeit benötigt wird, und sich dann eine relativ lange Zeitphase anschließt, während der ein niedriger Programmierstrom erforderlich ist.

Daher wird durch die erfindungsgemäße Schaltung während einer ersten Zeitdauer eine maximal zulässige Anzahl von Speicherzellen parallel geschaltet und jeweils mit einem ersten relativ hohen Programmierstrom beaufschlagt. Dieser Vorgang wird für den gesamten Speicher wiederholt. Während eines zweiten Testabschnitts werden dann eine entsprechend größere Anzahl von Speicherzellen parallel geschaltet und für die zweite Zeitdauer mit den relativ niedrigen Einzelprogrammierströmen beaufschlagt. Auf diese Weise kann vorteilhaft die Zeit für einen Speichertest verkürzt werden.

Ein weiterer Vorteil kann durch das zweistufige Testverfahren dadurch bewirkt werden, daß nach dem ersten Bestromen der Speicherzellen bereits ein Vorabtest der Speicherzellen erfolgen kann, da die aus den bis dahin programmierten Spannungswerten der Speicherzellen bereits eine erste Bewertung des Speichers erlaubt.

Die Erfindung wird nachfolgend anhand von zwei Figuren näher erläutert. Es zeigen

Figur 1    ein vereinfachtes Blockschaltbild eines programmierbaren nichtflüchtigen Speichers mit einer erfindungsgemäßen Schaltungsanordnung, und

Figur 2    den zeitlichen Verlauf der Spannung an einer Speicherzelle während des Programmierens.

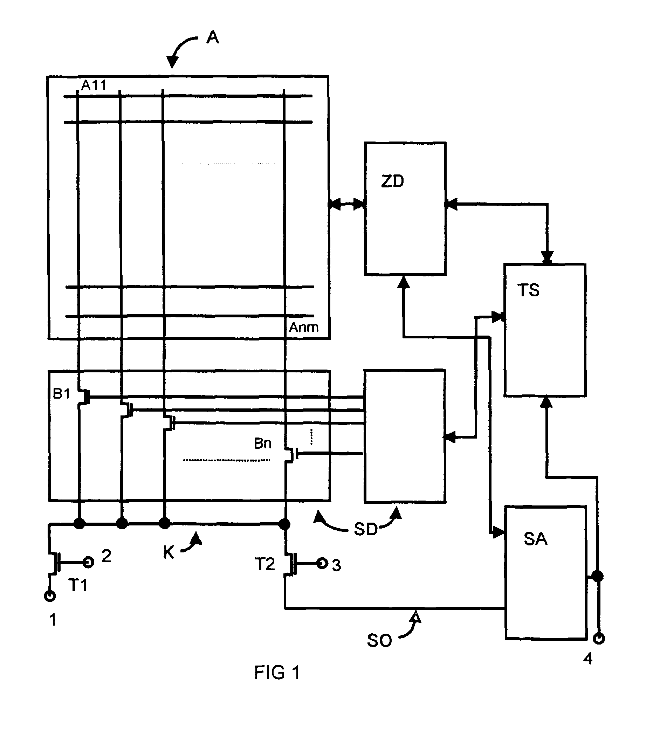

In Figur 1 ist mit A ein Block dargestellt, der Speicherzellen $A_{nm}$ enthält, welche in m Zeilen und n Spalten angeordnet sind. An jedem Kreuzungspunkt soll eine Speicherzelle angeordnet sein. Symbolisch sind zwei Speicherzellen die Zelle $A_{11}$ und die Zelle $A_{nm}$ markiert. Die einzelnen Zeilen dieser Speichermatrix werden durch den Zeilendekoder ZD dekodiert. Der Zeilendekoder wird wiederum durch eine Testschaltung TS angesteuert. Ein weiterer Dekoder für die Auswahl der Spalten ist mit SD bezeichnet. Er enthält unter anderem n Ansteuertransistoren $B_1...B_n$. Auch dieser Spaltendekoder SD wird durch die Testschaltung TS angesteuert. Die in dem Spaltendekoder SD enthaltenen Transistoren $B_1...B_n$ verbinden über ihre Laststrecken jeweils eine Spaltenleitung mit einer gemeinsamen Knotenpunktsleitung K.

Diese Knotenpunktsleitung K ist zum einen über die Laststrecke eines Steuertransistors T1 mit einer Anschlußklemme 1 verbunden. Das Gate dieses Transistors T1 ist mit einem Steueranschluß 2 verschaltet. Des weiteren ist die Knotenpunktsleitung K über die Laststrecke eines zweiten Transistors T2 mit der Spaltenausgangsleitung SO verbunden, die ihrerseits mit dem Sense-Amplifier SA verschaltet ist. Am Ausgang des Sense-Amplifiers SA ist an der Klemme 4 ein Ausgangssignal abgreifbar. Das Ausgangssignal des Sense-Amplifiers SA wird des weiteren der Testschaltung TS zugeführt.

Das Programmieren einer Zelle erfolgt mittels sogenannter "heißer Elektronen" in bekannter Weise. Dieses Programmierverfahren der Speicherzellen mit heißen Elektronen ist allgemein als CHE-Verfahren (Carrier Hot Electrons) bekannt. Im Gegensatz zum FN-Verfahren (Fowler Nordheim) wird hier ein verhältnismäßig großer Programmierstrom benötigt, da die Elektronenausbeute verhältnismäßig niedrig (< 1%) ist.

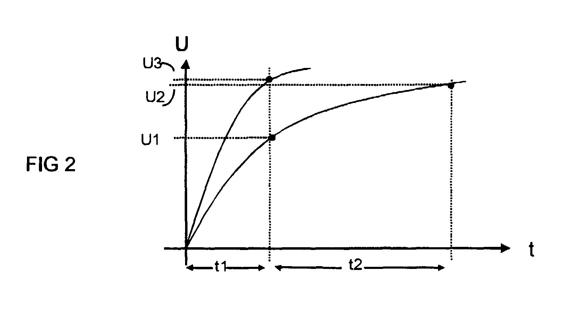

Figur 2 zeigt hierzu den typischen Verlauf der Einsatzspannung an einer zu programmierenden Speicherzelle $A_{nm}$. Wird eine derartige Zelle programmiert, so erhöht sich die Einsatzspannung während einer Zeitdauer $t_1$ relativ stark. Hierzu fließt ein großer Programmierstrom durch die Zelle, der mit der zunehmenden Zeit abnimmt. Während einer sich daran anschließenden zweiten Zeitdauer $t_2$ erreicht die Speicherzelle dann mittels eines deutlich geringeren Programmierstroms ihren endgültigen für eine Programmierung notwendigen Einsatzspannungswert.

Ein Testen des Speichers erfolgt nun folgendermaßen: An die Anschlußklemme 1 wird der eigentliche Programmierstrom angelegt. Dieser ist schaltungsbedingt auf einen maximalen Wert $I_{max}$ begrenzt. Dementsprechend kann nur eine begrenzte Anzahl von Speicherzellen gleichzeitig programmiert werden. Diese Anzahl ergibt sich aus der Division des Gesamtstroms $I_{max}$ durch den notwendigen Einzelstrom $I_{nm}$ für eine Speicherzelle. Demzufolge können z.B. q Speicherzellen während der Zeitdauer $t_1$ parallel geschaltet werden, wobei gilt:

$$q = \frac{I_{max}}{I_{nm}}$$

Die Testschaltung TS schaltet daher über den Spaltendekoder SD die entsprechende Anzahl q von Spalten parallel. Durch den Zeilendekoder ZD werden dann die jeweils parallel geschalteten Speicherzellen ausgewählt und über den Transistor T1, welcher durch ein entsprechendes Signal an der Klemme 2 angesteuert wird, wird die Knotenpunktsleitung K mit der Programmierspannung beaufschlagt, und der Programmierstrom für die einzelnen parallelgeschalteten Speicherzellen gelangt über die jeweiligen Transistoren $B_n$ an die Speicherzellen. Dieser Zustand wird für die Zeit $t_1$ aufrechterhalten. Nach der Zeit $t_1$ erreichen dann intakte Speicherzellen den Spannungswert U1. Dieser Vorgang wird nachfolgend sequentiell für alle übrigen Speicherzellen des gesamten Speichers durchgeführt, d.h. die Anzahl der Durchläufe p ergibt sich aus

$$p = \frac{n \cdot m}{q}$$

Nach dieser ersten Programmierstufe folgt die zweite Programmierstufe währen der Zeitdauer $t_2$. Während dieser Zeitdauer $t_2$ ist, wie in Figur 2 ersichtlich ist, ein geringerer Programmierstrom $I'_{nm}$ notwendig. Daher können nun eine größere Anzahl nämlich $q + x = \frac{I_{max}}{I'_{min}}$ programmiert werden. Das Zuführen dieses zweiten Teilprogrammierstroms $I'_{nm}$ erfolgt in gleicher Weise wie das Zuführen des ersten Teilprogrammierstroms. Nach der Zeitdauer $t_2$ erreicht der Spannungswert einer intakten Speicherzelle den Spannungswert U2.

Ob alle Speicherzellen diesen Sollspannungswert $U_2$ erreicht haben, kann nun in einem abschließendem Testlauf, durch Auslesen der einzelnen Speicherzellenwerte durch die Testschaltung TS in üblicher Weise ermittelt werden.

Eine defekte Zelle zeichnet sich nicht nur dadurch aus, daß sie den Spannungswert U1 während der ersten Programmierphase $t_1$ nicht erreicht, sondern vielmehr auch dadurch, daß sie diesen Wert U1 überschreitet und bereits nach der Zeitdauer $t_1$ einen erhöhten Spannungswert U3 erreicht. Liegt eine derartige Speicherzelle vor, so ist bekannt, daß diese zwar vorläufig intakt ist, aber man weiß, daß eine derartige Speicherzelle nach einer bestimmten Zeitspanne ausfällt.

Die erfindungsgemäße Schaltungsanordnung macht sich dies zunutze, indem sie in einer Weiterbildung einen ersten Testdurchlauf bereits nach der Zeitdauer $t_1$ durchführt. Schon jetzt kann nämlich ermittelt werden, ob der Speicher derartige in naher Zukunft ausfallende oder anderweitig defekte Speicherzellen enthält. Dies liegt dann vor, wenn der Wert $U_1$ deutlich unter- oder überschritten wird. Daher kann bei einem fehlerhaften Testergebnis während dieser Phase bereits festgestellt werden, daß der Speicher defekt ist und der Test abgebrochen werden, oder entsprechende Redundanzschaltungen aktiviert werden, die die defekten Zellen ersetzen.

Die erfindungsgemäßen Maßnahmen verkürzen einen Testdurchlauf für einen programmierbaren nichtflüchtigen Speicher erheblich. Die erfindungsgemäße Testschaltung kann sowohl bei normalen Speicherschaltungen, wie z.B. EPROMS verwendet werden oder wie eingangs erwähnt bei in Mikrokontrollerschaltungen mitintegrierten programmierbaren nichtflüchtigen Speichern.

**Patentansprüche**

1. Schaltungsanordnung für einen programmierbaren nichtflüchtigen Speicher (A), mit einer Vielzahl von in Reihen und Spalten organisierten Speicherzellen ($A_{nm}$) und mit einer Programmierschaltung, wobei zum Testen der Speicherzellen ($A_{nm}$) des Speichers (A) die Programmierschaltung Testmittel (TS, SD, ZD) enthält, die solange jeweils eine erste vorgegebene Anzahl (q) von Speicherzellen ($A_{nm}$) parallel für jeweils eine erste vorgegebene Zeitdauer ($t_1$) mit einem Programmierstrom ($I_{max}$) beaufschlagen, bis jede der Speicherzellen ($A_{nm}$) mit einem ersten Teilprogrammierstrom ($I_{nm} = I_{max}/q$) des Programmierstromes ($I_{max}$) beaufschlagt ist, **dadurch gekennzeichnet,** daß die Testmittel (TS, ZD, SD) nach der Beaufschlagung der Speicherzellen ($A_{nm}$) mit dem ersten Teilprogrammierstrom ($I_{nm} = I_{max}/q$) solange jeweils eine zweite vorgegebene Anzahl (q + x), die größer als die erste Anzahl (q) ist, für eine zweite vorgegebene Zeitdauer ($t_2$) mit dem Programmierstrom ($I_{max}$) beaufschlagen, bis jede der Speicherzellen ($A_{nm}$) mit einem zweiten Teilprogrammierstrom ($I_{nm'}=I_{max}/(q+x)$) des Programmierstromes ($I_{max}$) beaufschlagt ist.

**2.** Verfahren zum Betreiben einer Schaltungsanordnung nach Anspruch 1,
**dadurch gekennzeichnet,**
daß die Testmittel (TS, ZD, SD) nach der Beaufschlagung der Speicherzellen ($A_{nm}$) mit dem zweiten Teilprogrammierstrom ($I_{nm'}=I_{max}/(q+x)$) überprüfen, ob jede der Speicherzellen ($A_{nm}$) beschrieben ist.

**3.** Verfahren zum Betreiben einer Schaltungsanordnung nach einem der Ansprüche 1 oder 2,
**dadurch gekennzeichnet,**
daß die Testmittel (TS, ZD, SD) nach der Beaufschlagung der Speicherzellen ($A_{nm}$) mit dem ersten Teilprogrammierstrom ($I_{nm}=I_{max}/q$) überprüfen, ob jede der Speicherzellen ($A_{nm}$) beschrieben ist.

**4.** Schaltungsanordnung nach einem der Ansprüche 2 oder 3,
**dadurch gekennzeichnet,**
daß eine Komparatorschaltung vorgesehen ist, die einen Spannungswert an der zu überprüfenden Speicherzelle ($A_{nm}$) überprüft.

**5.** Verfahren zum Betreiben einer Schaltungsanordnung nach einem der vorhergehenden Ansprüche,
**dadurch gekennzeichnet,**
daß die Testmittel (ZD, SD) eine Vielzahl von Spalten parallel schalten und durch Auswählen einer Zeile die jeweilige Vielzahl von Speicherzellen ($A_{nm}$) parallel adressiert.


**Claims**

**1.** Circuit arrangement for a programmable nonvolatile memory (A), having a multiplicity of memory cells ($A_{nm}$) organized in rows and columns and having a programming circuit,
in order to test the memory cells ($A_{nm}$) of the memory (A), the programming circuit containing test means (TS, SD, ZD), which apply a programming current ($I_{max}$) in each case to a first predetermined number (q) of memory cells ($A_{nm}$) in parallel for a respective first predetermined time period ($t_1$) until a first partial programming current ($I_{nm}=I_{max}/q$) of the programming current ($I_{max}$) has been applied to each of the memory cells ($A_{nm}$),
characterized in that
after the first partial programming current ($I_{nm}=I_{max}/q$) has been applied to the memory cells

($A_{nm}$), the test means (TS, ZD, SD) apply the programming current ($I_{max}$) in each case to a second predetermined number (q + x), which is greater than the first number (q), for a second predetermined time period ($t_2$) until a second partial programming current ($I_{nm'}=I_{max}/(q+x)$) of the programming current ($I_{max}$) has been applied to each of the memory cells ($A_{nm}$).

**2.** Method for operating a circuit arrangement according to Claim 1,
characterized in that
after the second partial programming current ($I_{nm'}=I_{max}/(q+x)$) has been applied to the memory cells ($A_{nm}$), the test means (TS, ZD, SD) check whether each of the memory cells ($A_{nm}$) has been written to.

**3.** Method for operating a circuit arrangement according to either of Claims 1 and 2,
characterized in that

after the first partial programming current ($I_{nm}=I_{max}/q$) has been applied to the memory cells ($A_{nm}$), the test means (TS, ZD, SD) check whether each of the memory cells ($A_{nm}$) has been written to.

**4.** Circuit arrangement according to either of Claims 2 and 3,
characterized in that
a comparator circuit is provided which checks a value of the voltage across the memory cell ($A_{nm}$) to be checked.

**5.** Method for operating a circuit arrangement according to one of the preceding claims,
characterized in that
the test means (ZD, SD) connect a multiplicity of columns in parallel and address the respective multiplicity of memory cells ($A_{nm}$) in parallel by selection of a row.


**Revendications**

**1.** Configuration de circuit pour une mémoire programmable (A) non volatile, pourvue d'une pluralité d'emplacements mémoire ($A_{nm}$) organisés en rangées et en colonnes et d'un circuit de programmation,
dans laquelle, pour tester les emplacements mémoire ($A_{nm}$) de la mémoire (A), le circuit de programmation comporte des moyens de test (TS, SD, ZD) qui alimentent en parallèle un premier nombre (q) donné à l'avance d'emplacements mémoire ($A_{nm}$) pendant un premier laps de temps ($t_1$) donné à l'avance en un courant de programmation ($I_{max}$),

jusqu'à ce que chaque emplacement mémoire ($A_{nm}$) soit alimenté en un premier courant partiel de programmation ($I_{nm} = I_{max}/q$) du courant de programmation ($I_{max}$),

caractérisée en ce que les moyens de test (TS, ZD, SD) alimentent, après l'alimentation des emplacements mémoire ($A_{nm}$) en le premier courant partiel de programmation ($I_{nm} = I_{max}/q$), un deuxième nombre donné ($q + x$) donné à l'avance, qui est supérieur au premier nombre ($q$), pendant un deuxième laps de temps ($t_2$) donné à l'avance en le courant de programmation ($I_{max}$), jusqu'à ce que chacun des emplacements mémoire ($A_{nm}$) soit alimenté en un deuxième courant partiel de programmation ($I_{nm'} = I_{max}/(q + x)$) du courant de programmation ($I_{max}$).

2. Procédé pour faire fonctionner une configuration de circuit selon la revendication 1,

caractérisé en ce que

les moyens de test (TS, ZD, SD) contrôlent, après l'alimentation des emplacements mémoire ($A_{nm}$) en le deuxième courant partiel de programmation ($I_{nm'} = I_{max}/(q + x)$), si chacun des emplacements mémoire ($A_{nm}$) a reçu une écriture

3. Procédé pour faire fonctionner une configuration de circuit selon l'une des revendications 1 ou 2,

caractérisé en ce que,

les moyens de test (TS, ZD, SD) contrôlent, après l'alimentation des emplacements mémoire ($A_{nm}$) en le premier courant partiel de programmation ($I_{nm}=I_{max}/q$), si chacun des emplacements mémoire ($A_{nm}$) a reçu une écriture.

4. Configuration de circuit selon l'une des revendications 2 ou 3,

caractérisée en ce qu'il est prévu un circuit comparateur qui contrôle une valeur de tension de l'emplacement mémoire ($A_{nm}$) à contrôler.

5. Procédé pour faire fonctionner une configuration de circuit selon l'une des revendications précédentes,

caractérisé en ce que,

les moyens de test (ZD, SD) branchent en parallèle une pluralité de colonnes et, par la sélection d'une ligne, adressent en parallèle la pluralité d'emplacements mémoire ($A_{nm}$).

FIG 1

FIG 2